# EUROPEAN PATENT APPLICATION

(11) **EP 0 720 154 A2**
(43) Date of publication of application: **03.07.1996**
(21) Application number: 95309423.2
(22) Date of filing: 22.12.1995
(51) Int. Cl.: G11B 5/39, C23C 14/18

(54) **An electrode thin film for such as magnetoresistive effect head and a method of manufacturing the same**

(30) Priority: 26.12.1994 JP 321919/94
(71) Applicant: NEC Corporation, Minato-ku, Tokyo 108-01 (JP)
(72) Inventor: Fukami, Eizou, Minato-ku, Tokyo (JP)
(74) Representative: Moir, Michael Christopher

(57) **Abstract**

An electrode thin film (7,8) having an electrode part constituted by a tantalum-molybdenum alloy thin film (7) of a bocy centered cubic crystal structure crystal system is formed. An electrode thin film having an electrode part formed by sputtering in the atmosphere of a blend gas obtained by adding 5 % or below of nitrogen gas to argon gas or the like is formed. A magnetoresistive effect head, which comprises a soft magnetic thin film (2), a non-magnetic spacer thin film (3), a magnetoresistive thin film (4), an antiferromagnetic exchange bias thin film (5), and a first electrode thin film (7), these thin films being laminated successively on a substrate (1), predetermined regions of the anti-magnetic effect thin film (5), first electrode thin film (7), etc. are cut off to form an operative zone (Tw), the non-magnetic spacer thin film (3) and first electrode thin film (5) is tantalum-molybdenum alloy thin films. The tantalum-molybdenum alloy thin film as the non-magnetic spacer thin film is of a predetermined mixed crystal structure.

## Description

### BACKGROUND OF THE INVENTION

The present invention relates to electrode thin films magnetoresistive effect heads and magnetoresistive effect heads having a function of reading data based on magnetoresistive effect, and method of manufacturing the same.

Thin films of tantalum (Ta) have been used as electrode film of magnetoresistive effect heads. As varieties of tantalum, there are α-tantalum having a body centered cubic crystal structure and β-tantalum having a tetragonal crystal structure. A thin film of tantalum which is formed through a sputtering process is usually β-tantalum having a teragonal crystal structure, and its resistivity is as high as 180 to 220 [µΩ·cm] (as disclosed in, for instance, "Applied Physics Letters", Vol. 7, pp. 51-52, 1965). A thin film of tantalum nitride (TaN) which is sputtered by using a mixture gas of argon (Ar) and nitrogen (N₂), has as low resistivity as 60 to 70 [µΩ·cm]. These thin films have been used extensively as an electrode thin film of magnetoresistive effect heads.

The thin film of tantalum (Ta) noted above, however, has high resistivity. The thin film of tantalum nitride (TaN) in contrast is low in resistivity, but it has a demerit that its manufacture margin is very narrow (as shown in, for instance, Proceeding of IEEE, Vo.l. 52, pp. 1450-1462, 1964), making it difficult to obtain a thin film having stable characteristics. A tantalum-molybdenum alloy thin film which is obtainable by adding 15 atomic % or above of molybdenum to tantalum, has low resistivity and wide manufacture margin. Molybdenum, however, is readily subject to corrosion, and in the tantalum-molybdenum alloy thin film the corrosion resistance and etching solution resistance become poorer with increasing the molybdenum proportion.

Hitherto, tantalum thin films formed by the sputtering process have been used as the electrode thin film of magnetoresistive effect heads. These thin films are of β-tantalum having the tetragonal crystal structure and have as high resistivity as 180 [µΩ·cm]. Therefore, they lead to high resistivity of the head element and constitute sources of heat and noise, so that they are unsuitable for high performance magnetoresistive effect heads. As for tantalum nitride thin films, it is difficult to manufacture these films having low resistivity, so that they are unsuitable for the manufacture of the electrode thin films for magnetoresistive effect heads or the like.

Tantalum-molybdenum alloy thin films contain 15 atomic % and above of molybdenum and pose problems in view of the corrosion resistance. In the manufacture of a magnetoresistive effect head, such metals as gold and copper and photoresist that are used as stencil materials to prepare a head element pattern are etched or removed by using an etching solution or an organic solvent. In this case, tantalum-molybdenum alloy thin film as electrode thin film is liable to be exposed and corroded or etched.

In another aspect, in the magnetoresistive effect head a high resistivity tantalum thin film which is formed by means of sputtering is used as a non-magnetic spacer thin film. A target for the sputtering can not be used commonly for a low resistivity tantalum-molybdenum alloy thin film which may be used as the electrode thin film. Practically, separate apparatuses are required for these thin films, or it is necessary to replace the target for forming each thin film, thus leading to increase of the cost of manufacture or increase of the steps of manufacture.

### SUMMARY OF THE INVENTION

The present invention seeks to preclude the inconveniences inherent in the prior art, and has an object to provide an electrode thin film, which has low resistivity and is excellent in the corrosion resistance, etching solution resistance, etc., as well as a method of manufacturing the same and a magnetoresistive effect head which uses the same thin film, has low resistivity, generates low noise and is highly reliable.

In the present invention, an electrode thin film having an electrode part constituted by a tantalum-molybdenum alloy thin film of a body centered cubic crystal structure is formed. An electrode thin film having an electrode part sputtered in the atmosphere of a blend gas obtained by adding 5 % or below of nitrogen gas to argon gas or the like is formed. A magnetoresistive effect head comprises a soft magnetic thin film, a non-magnetic spacer thin film, a magnetoresistive effect thin film, an antiferromagnetic exchange bias thin film, and a first electrode thin film. These thin films are laminated successively on a substrate. Predetermined regions of the antiferromagnetic exchange bias thin film, first electrode thin film, etc. are cut off to form an active region. The non-magnetic spacer thin film and first electrode thin film is tantalum-molybdenum alloy thin films. The tantalum-molybdenum alloy thin film as the non-magnetic spacer thin film is of a predetermined mixed crystal structure.

It was experimentally confirmed that a tantalum-molybdenum alloy thin film can reduce the resistivity to about one-fourth compared to the case of using a tantalum thin film and also enhance the corrosion resistance. A high resistivity non-magnetic spacer thin film and a low resistivity electrode thin film can be formed by using the same target and in a reduced number of steps. By incorporating the above electrode thin film it is possible to obtain a magnetoresistive head, which can provide low resistivity of the head element, while generating low heat and low noise.

Other objects and features will be clarified from the following description with reference to attached drawings.

### BRIEF DESCRIPTION OF THE DRAWINGS

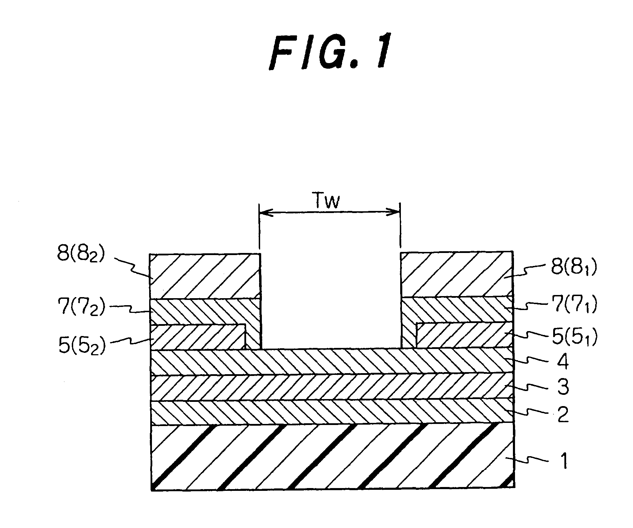

Fig. 1 is a cross-sectional showing a first embodiment of the present invention;

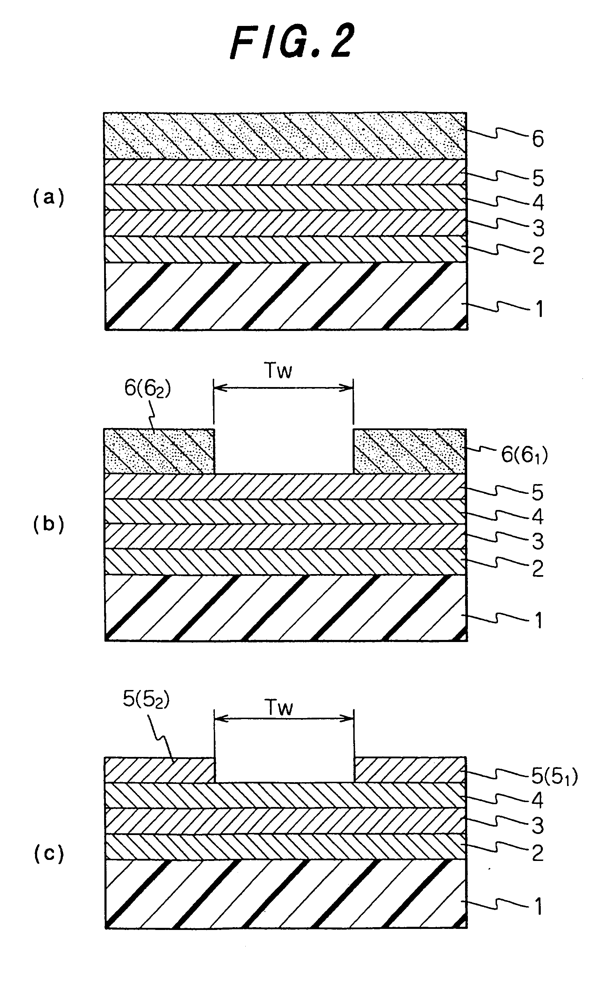

Figs. 2(a) to 2(c) are cross-sectional views showing the process of manufacture of the Fig. 1 embodiment, in which Fig. 2(a) shows a state with a photoresist formed on an antiferromagnetic exchange bias thin film, Fig. 2(b) shows a state with an adequate pattern exposed and developed, and Fig. 2(c) shows a state with a sensor operation region formed in an antiferromagnetic exchange bias thin film portion;

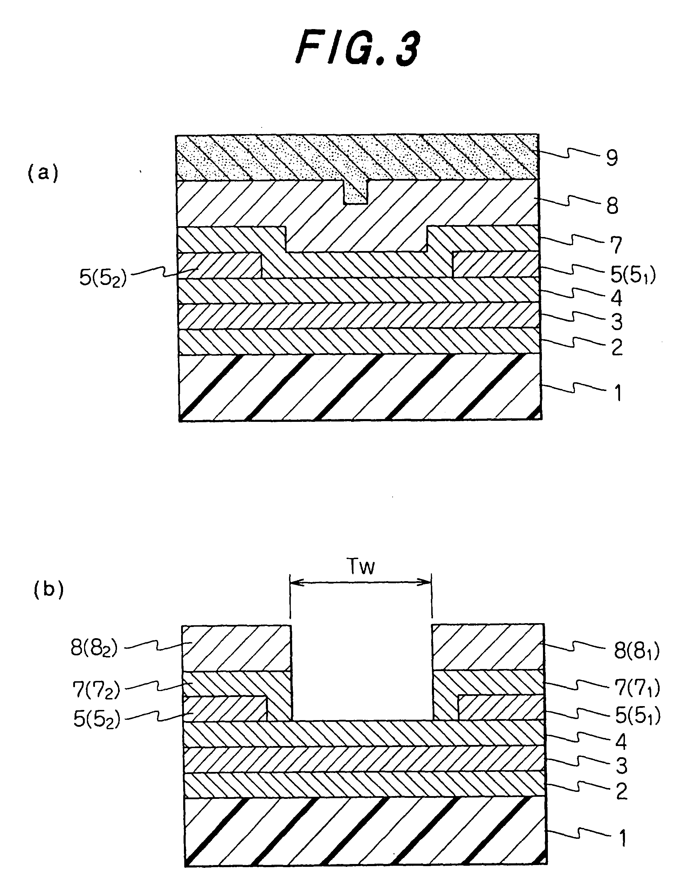

Figs. 3(a) and 3(b) are cross-sectional views showing a continuation of the Figs. 2(a) to 2(c) process, in which Fig. 3(a) shows a state in which a first electrode film, a second electrode film and a photoresist are successively formed, and Fig. 3(b) shows a state with an operation area formed on the structure of Fig. 3(a);

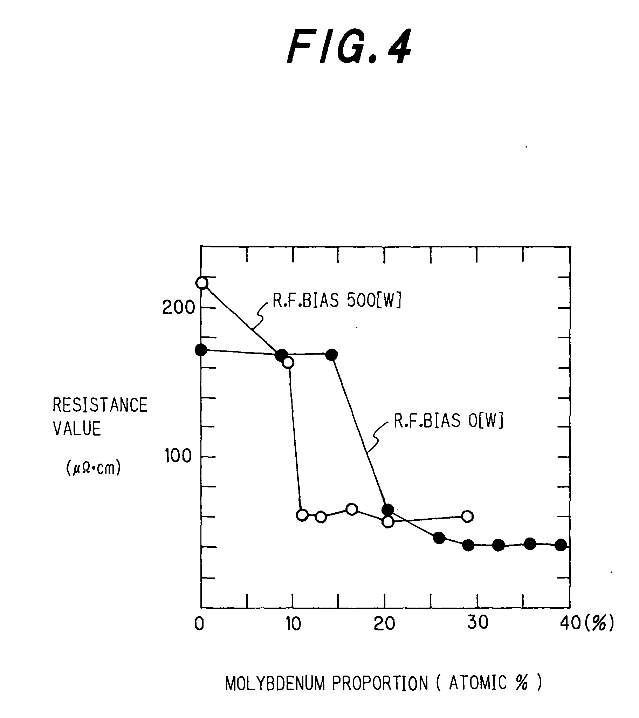

Fig. 4 is a graph showing the molybdenum proportion dependence of the resistivity of a tantalum-molybdenum alloy thin film as a material of a first electrode thin film shown in Fig. 1;

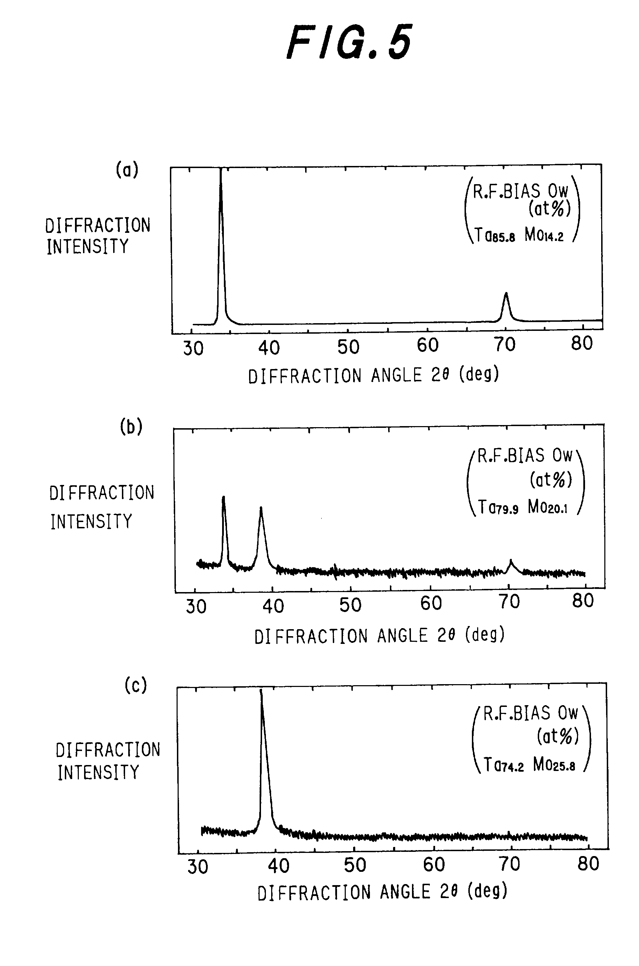

Figs. 5(a) to 5(c) are graphs showing X-ray diffraction patterns of tantalum-molybdenum alloy thin films prepared without bias for examining the characteristics of the thin films, in which Fig. 5(a) shows the pattern of a tantalum-molybdenum alloy thin film with a molybdenum proportion of 14.2 atomic %, Fig. 5(b) shows the pattern of a tantalum-molybdenum alloy thin film with a molybdenum proportion of 20.1 atomic %, and Fig. 5(c) shows the pattern of a tantalum-molybdenum alloy thin film with a molybdenum proportion of 25.8 atomic %;

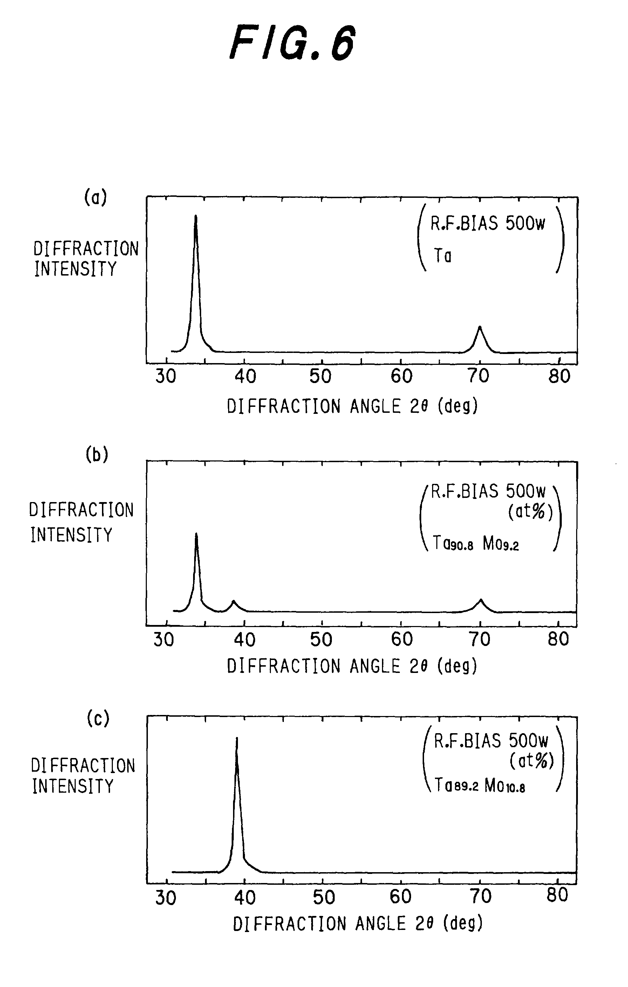

Figs. 6(a) to 6(c) are graphs showing X-ray diffraction patterns of tantalum-molybdenum alloy thin films prepared with a bias of 500 W for examining the characteristics of the thin films, in which Fig. 6(a) shows the pattern of a tantalum thin film, Fig. 6(b) shows the pattern of a tantalum-molybdenum alloy thin film with a molybdenum proportion of 9.2 atomic %, and Fig. 6(c) shows the pattern of a tantalum-molybdenum alloy thin film with a molybdenum proportion of 10.8 atomic %;

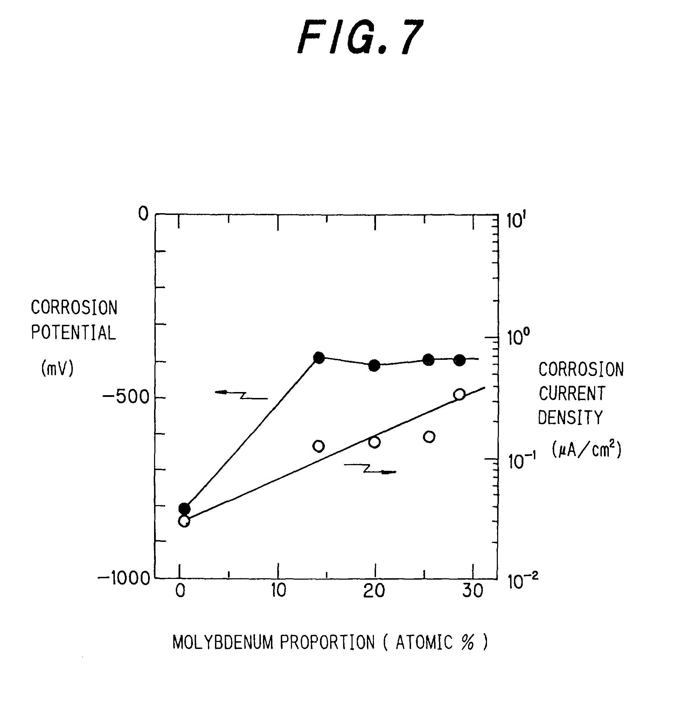

Fig. 7 is a graph showing the molybdenum proportion dependence of the corrosion potential and corrosion current density of tantalum-molybdenum alloy thin films prepared without bias as determined from the potentiodynamic scans measurement using 0.2 N sulfuric acid electrolyte for examining the characteristics of the thin films;

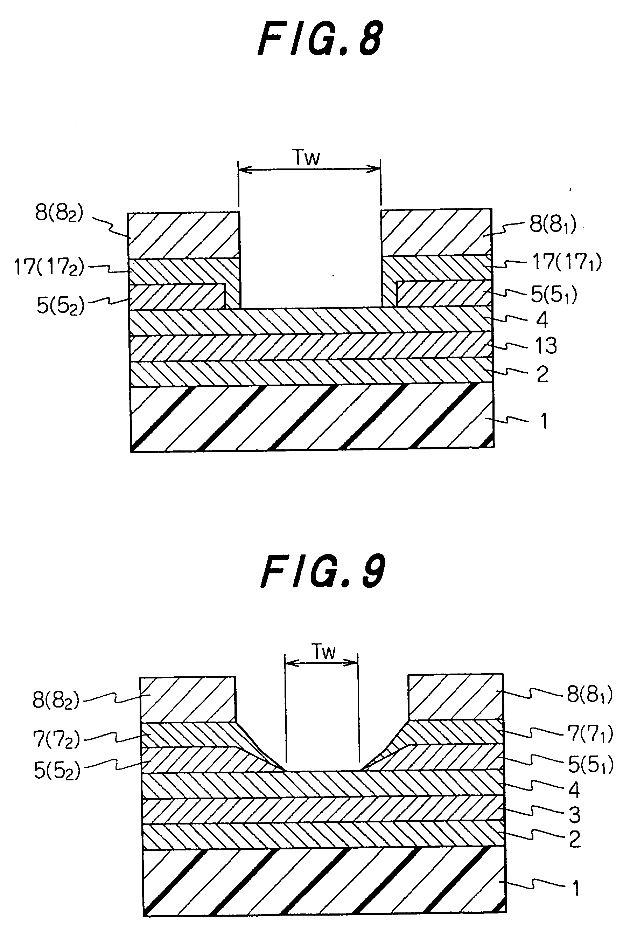

Fig. 8 is a cross-sectional view showing a second embodiment of the present invention;
Fig. 9 is a cross-sectional view showing a third embodiment of the present invention;

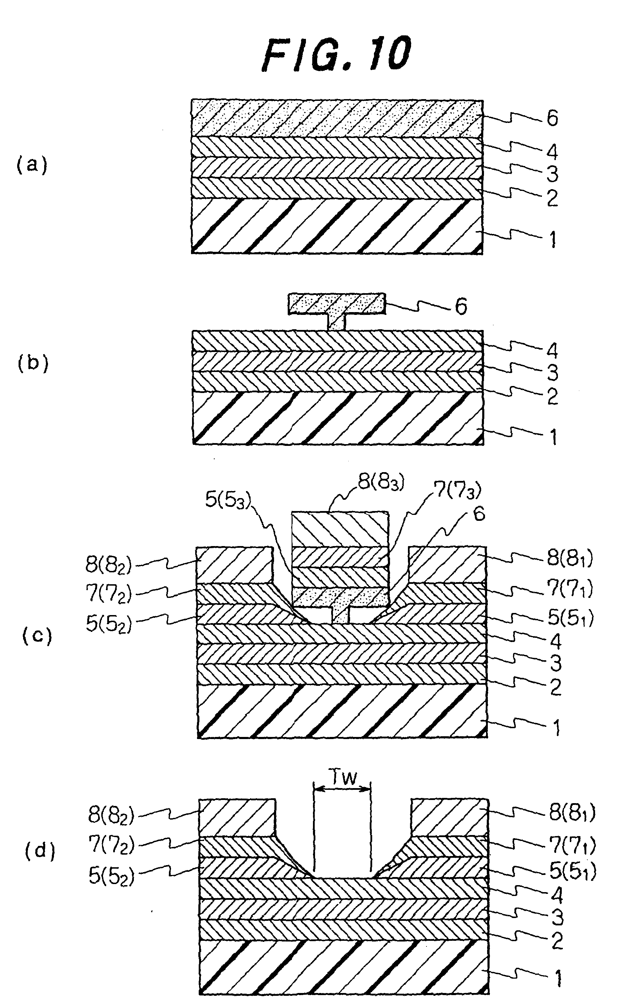

Figs. 10(a) to 10(d) are views showing the process of manufacture of the Fig. 9 third embodiment, in which Fig. 10(a) shows a state with a photoresist formed on a magnetoresistive effect thin film, Fig. 10(b) shows a state with a stencil pattern formed through exposure and development,
Fig. 10(c) shows a state with an antiferromagnetic exchange bias thin film, a first electrode thin film and a second electrode thin film formed after the Fig. 10(b) step, and Fig. 10(d) showing a state after removal of the photoresist on the sensor operation region and a laminated film on the photoresist shown in Fig. 10(c);

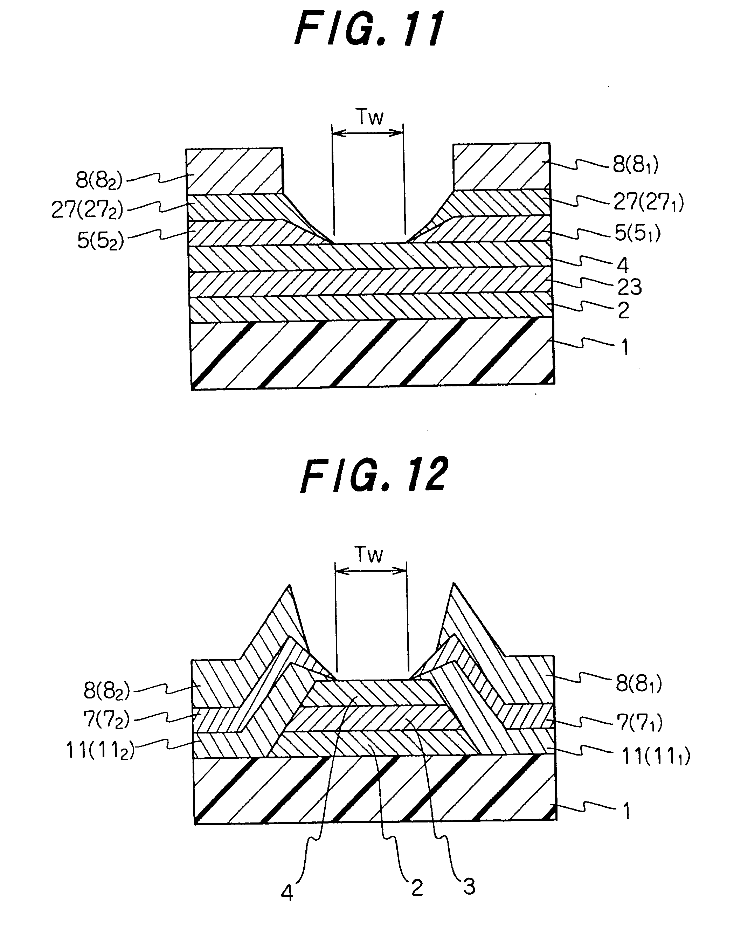

Fig. 11 is a cross-sectional view showing a fourth embodiment of the present invention;
Fig. 12 is a cross-sectional view showing a fifth embodiment of the present invention;

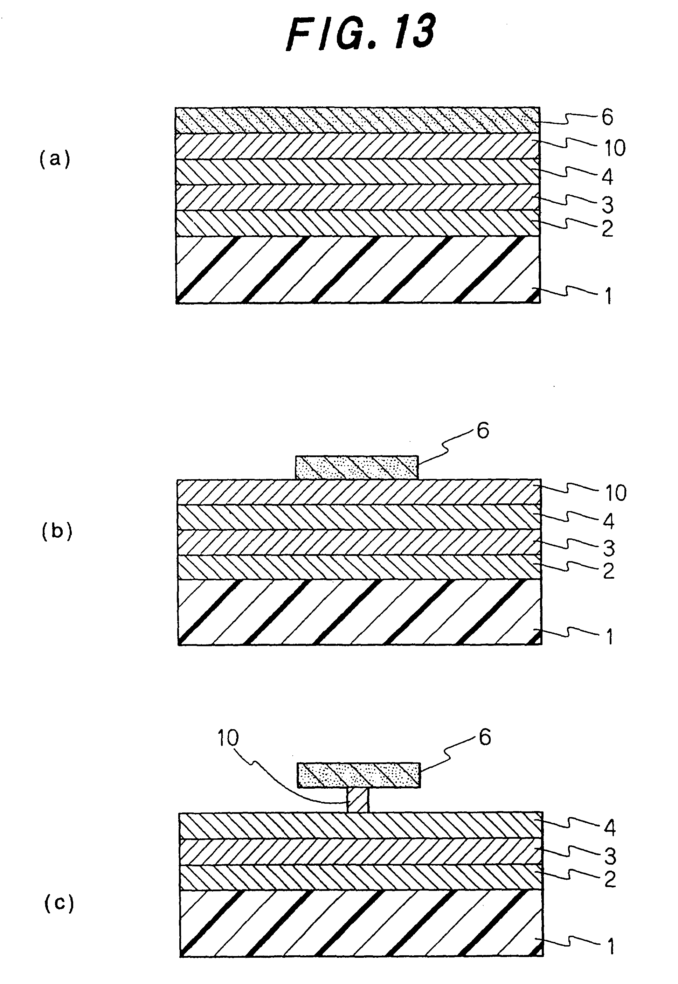

Figs. 13(a) to 13(c) show the process of manufacture of the Fig. 12 fifth embodiment, in which Fig. 13(a) shows a state with a photoresist formed on a stencil shaft portion metal thin film, Fig. 13(b) shows a state with a predetermined photoresist pattern obtained through exposure and development, and Fig. 13(c) shows a state with a stencil shaft portion metal thin film patterned after the Fig. 13(b) step;

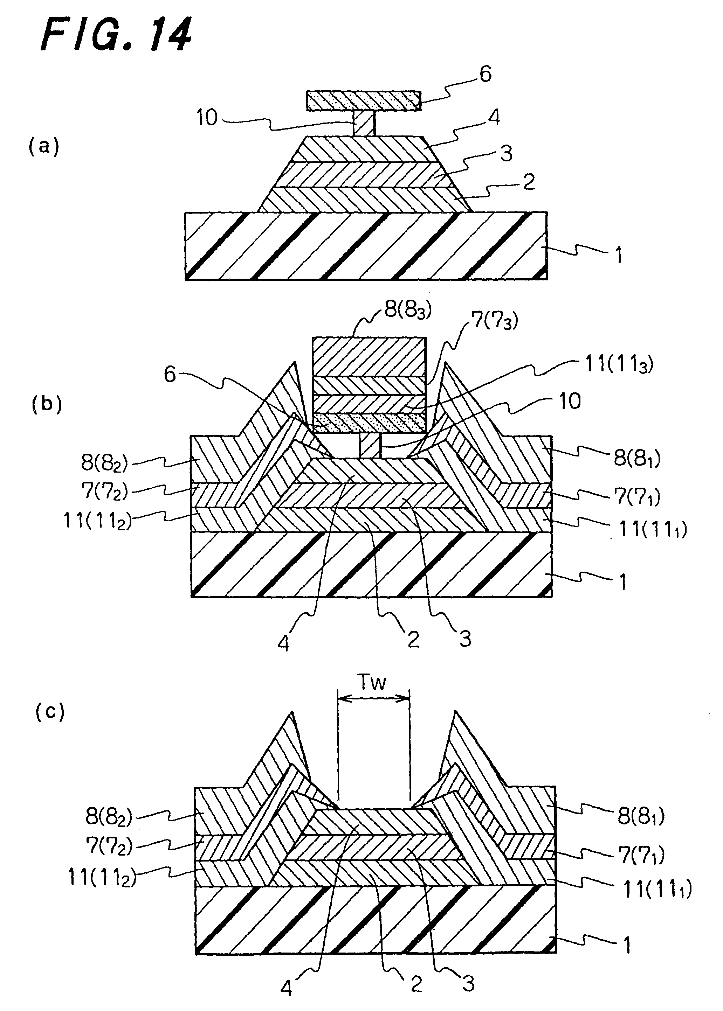

Figs. 14(a) to 14(c) are cross-sectional views showing a continuation of the Figs. 13(a) to 13(c) process of manufacture of the fifth embodiment, in which Fig. 14(a) shows a state with lip portions of a soft magnetic thin film, a non-magnetic spacer thin film and a magnetoresistive effect thin film shown in Fig. 13(b) processed to a trapezoidal cross-sectional profile through ion milling with an inclination angle of 45 degrees, Fig. 14(b) shows a state with a hard magnetic transverse bias thin film, a first electrode thin film and a second electrode thin film shown in Fig. 14(a), and Fig. 14(c) shows a state after removal of a stencil shaft portion metal thin film on a sensor operation region and a laminated layer on the thin film shown in Fig. 14(b); and

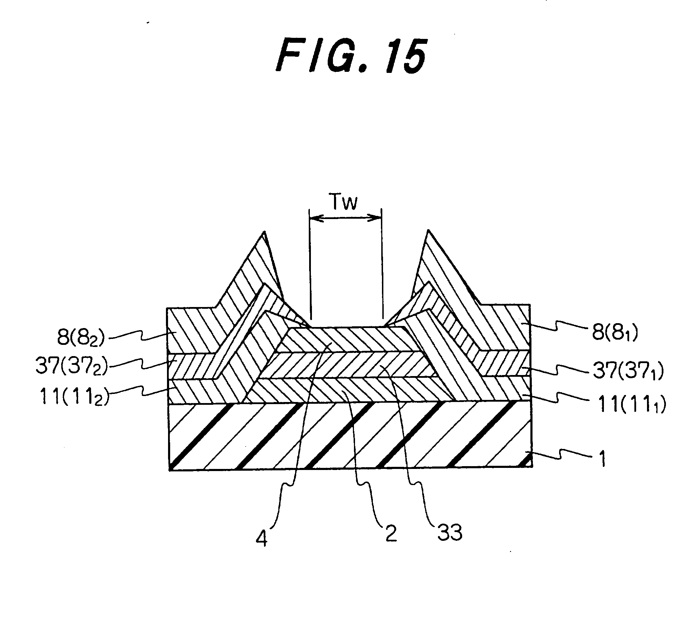

Fig. 15 is a cross-sectional view showing a sixth embodiment of the present invention.

### DETAILED DESCRIPTION OF THE PREFERRED EMBODIMENTS

A first embodiment of the present invention will now be described with reference to Figs. 1 to 7.

This embodiment, which is applied to a magnetoresistive effect head, comprises a soft magnetic thin film 2, a non-magnetic spacer thin film 3, a magnetoresistive effect thin film 4, an antiferromagnetic exchange bias thin film 5, a first electrtode thin film 7 and a second electrode thin film 8, these films being laminated successively on a ceramic substrate 1. As shown in Fig. 1, the structure has an operative zone Tw having a predetermined width, which is formed by cutting off central portions of the antiferromagnetic exchange bias thin film 5 and first and second electrode thin films 7 and 8. The operative zone Tw divides each of the first and second electrode thin films 7 and 8, and antiferromagnetic exchange bias thin film 5 into two parts, i.e., first electrode thin films 7₁ and 7₂, second electrode thin films 8₁ ad 8₂, and antiferromagnetic bias thin films 5₁ and 5₂.

The ceramic substrate 1 comprises an Al₂O₃-TiC type ceramic. The soft magnetic thin film 2 comprises a cobalt-zirconium-molybdenum alloy and has a thickness of 50 angstroms. The non-magnetic spacer thin film 3 comprises tantalum and has a thickness of 200 angstroms. The magnetoresistive effect thin film 4 comprises a nickel-iron alloy and has a thickness of 200 angstroms. The antiferromagnetic exchange bias thin film 5 comprises an iron-maganese alloy and has a thickness of 150 angstroms. The above films are laminated successively by sputtering.

The process of manufacturing the above magnetoresistive effect head will now be described with reference to Figs. 2(a) to 2(c), 3(a) and 3(b).

First, as shown in Fig. 2(a), the soft magnetic thin film 2, non-magnetic spacer thin film 3, magnetoresistive effect thin film 4 and antiferromagnetic exchange bias thin film 5 were laminated successively by sputtering on the ceramic substrate 1. A photoresist having a thickness of one micron was then coated on the laminate. Then, as shown in Fig. 2(b), a portion of the photoresist 6 in the operative zone Tw, acting as a magnetoresistive effect sensor, was patterned through exposure and development under appropriate conditions. Then, as shown in Fig. 2(c), a portion of the antiferromagnetic exchange bias thin film 5, of an iron-manganese alloy, in the operative zone Tw free from the photoresist 6, was removed by means of ion milling or chemical etching. Thereafter, the remaining photoresist 6 was removed by using acetone or like organic solvent. At this time, the photoresist 6 may be removed more perfectly and more quickly by using ultrasonic wave washing or the like in combination.

Then, as shown in Fig. 3(a), as the first electrode thin film 7 a tantalum-molybdenum alloy thin film with a molybdenum proportion of 10.8 atomic % and having the body centered cubid crystal structure, was formed to a thickness of 500 angstroms by sputtering with a bias of 500 W, with an output of 1.0 kW and in an argon gas atmosphere under a pressure of 1.7 mTorr. Then as the electrode thin film 8 a gold thin film having a thickness of 1 micron was formed, and the photoresist 9 having a thickness of 1.5 microns was then formed on the thin film 8. The second electrode thin film 8 may be made of any material having low resistivity and excellent corrosion resistance. It is further possible to substitute the tantalum-molybdenum thin film as the first electrode thin film 7 for the first electrode thin film 8 by increasing the total thickness of the former thin film to one microm. Then, as shown in Fig. 3(c), a portion of the photoresist 9 in the operative zone Tw was patterned through exposure and development under appropriate conditions. Then, portions of the gold thin film as the second electrode thin 8 film and the tantalum-molybdenum alloy thin film as the first electrode thin film 7 in the operative zone Tw were removed by means of ion milling or chemical etching, and then the remaining photoresist 9 was removed by using acetone or like organic solvent. Thus, a magnetoresistive effect head was obtained. The photoresist 9 may be removed more perfectly and more quickly by using ultrasonic wave washing or the like in combination.

The resistance of the magnetoresistive effect head thus obtained was measured to find that as small value as 5 Ω is obtainable. It was also found that heat generation can be suppressed. Readback characteristics were examined to find that satisfactory readback waveforms with less noise due to the head are obtainable.

The above tantalum-molybdenum alloy thin film as the first electrode thin film 7 will now be described with reference to Figs. 4 to 7.

The basic characteristics of the tantalum-molybdenum alloy thin film will now be described. Fig. 4 shows the molybdenum proportion dependence of the resistivity of tantalum-molybdenum alloy thin films, which were formed on the glass substrate by sputtering with biases of 0 and 500 W and an output of 1.0 kW in an argon gas atmosphere under a pressure of 1.7 mTorr.

The resistivity of the tantalum-molybdenum alloy thin films that were manufactured without bias was sharply reduced to 40 to 50 [µΩ·cm] as the molybdenum proportion was increased beyond 15 atomic %.

The resistivity of the tantalum-molybdenum alloy thin films that were formed with the bias of 500 W was sharply reduced to 50 to 60 [µΩ·cm] as the molybdenum proportion was incresed beyond 10 atomic %.

It is possible, by applying a bias of 100 W in manufacture, to obtain a molybdenum proportion dependence of resistivity that is coincident with one obtainable with a bias of 500 W as shown in Fig. 4. More specifically, as for the resistivity of the tantalum-molybdenum alloy thin films with a molybdenum proportion range of 10 to 15 atomic %, by applying a bias ranging from 100 to 500 W it is possible to obtain a tantalum-molybdenum alloy thin film having low resisivity with the same molybdenum proportion as of a tantalum-molybdenum alloy thin film formed with a bias of 100 W or below.

The power output and argon gas atmosphere pressure noted above are by no means limitative; the power may be in a range of 0.1 to 5.0 kW, and the pressure may be in a range of 0.5 to 50 mTorr. The lower limits of these conditions of manufacture are prescribed by the conditions which allow stable generation and continuance of electric discharge during the sputtering. Specifically, the upper limit of the pressure is prescribed by the quality of the tantalum-molydenum alloy thin film. The higher the pressure, the surface of the obtained thin film has the greater unevenness. When the pressure is excessive, a low density and porous thin film is formed, which is unsuitable as the electrode thin film.

Figs. 5(a) to 5(c) show X-ray diffraction patterns of tantalum-molybdenum alloy thin films formed under bias-free condition. Fig. 5(a) shows the X-ray diffraction pattern of a tantalum-molybdenum thin film with a molybdenum proportion of 14.2 atomic %. Fig. 5(b) shows the X-ray diffraction pattern of a tantalum-molybdenum alloy thin film with a molybdenum proportion of 20.1 atomic %. Fig. 5(c) shows the X-ray diffraction pattern of a tantalum-molybdenum alloy thin film with a molybdenum proportion of 25.8 atomic %.

Figs. 6(a) to 6(c) show X-ray diffraction patterns of tantalum-molybdenum alloy thin films formed with a bias of 500 W. Fig. 6(a) shows an X-ray diffraction pattern of a tantalum (Ta) thin flim. Fig. 6(b) shows an X-ray diffraction pattern of a tantalum-molybdenum alloy thin film with a molybdenum proportion of 9.2 atomic %. Fig. 6(c) shows an X-ray diffraction pattern of a tantalum-molybdenum alloy thin film with a molybdenum proportion of 10.8 atomic %.

Diffraction peaks that appear near diffraction angles of 33 and 70 degrees, correspond to the (0, 0, 2) and (5, 1, 3) planes, respectively, of the tetragonal crystal structure, and a diffraction peak appearing near 38 degrees corresponds to the (1, 1, 0) plane of the body centered cubid crystal structure. Thus, it is seen from Figs. 5(a) and 6(a) that a high resistivity Ta thin film is of the tetragonal crystal structure, and it is seen from Figs. 5(c) and 6(c) that a tantalum-molybdenum alloy thin film having a sufficiently reduced resistivity is of the body centered cubid crystal structure.

Tantalum-molybdenum alloy thin films having molybdenum proportions around the value corresponding to sharp reduction of the resistivity, are of mixed crystals in which the tetragonal crystal structure and body centered cubid crystal structure are compounded, as is seen from Fig. 5(b) and 6(b). When the resistivity is not reduced, the X-ray diffraction peak of the thin film that represents a body centered cubid crystal structure with a diffraction angle around 38 degrees is small as is seen from Fig. 6(b). On the other hand, when the resistivity is reduced, the corresponding X-ray diffraction peak is large. From these facts, it is confirmed that the sharp resistivity reduction is attributable to a structure transition from the tetragonal crystal structure to the body centered cubid crystal structure. It has further been found that the resistivity of even a mixed crystal with the compounded tetragonal crystal and body centered cubid crystal structures, is greatly reduced when the X-ray diffraction peak intensity ratio of the (0, 0, 2) plane of the tetragonal crystal structure to the (1, 1, 0) plane of the body centered cubid crystal structure becomes less than 0.5.

Fig. 7 shows the molybdenum proportion dependence of the corrosion potential and corrosion current density of tantalum-molybdenum alloy thin films formed without bias, as determined from anodic polarization characteristic measurements using 0.3 N sulfuric acid as electrolyte. As is seen, with the tantalum-molybdenum alloy thin film the corrosion potential is high compared to the tantalum thin film, indicating that the former thin film is of a nobler metal than the latter thin film.

The corrosion current density, on the other hand, is low with the tantalum-molybdenum alloy thin film compared to the tantalum thin film, and it is increased with increasing molybdenum proportion. So far as the scope of experiments conducted by the inventors is concerned, the structure of crystal is a predominating factor of influence on the magnitude of the corrosion potential, and it is understood that the transition of the tetragonal crystal structure obtained with the tantalum thin film formed by sputtering to the body centered cubid crystal structure obtained with the tantalum-molybdenum alloy thin film, has an effect of increasing the corrosion potential, thus improving the corrosion resistance of the tantalum-molybdenum alloy thin film.

The corrosion current density, on the other hand, is predominatingly dependent on the molybdenum proportion and increased monotonously with increasing molybdenum proportion. This fact supports that an electrochemical reaction that once takes place proceeds more quickly with a thin film having a greater molybdenum proportion. Similar results could be obtained from anodic polarization characteristic measurements.

Through a four-probe method after dipping in a solution containing iodine, potassium iodide and water in proportions of "1 : 2 : 200" several different tantalum-molybdenum alloy thin films having a thickness of 800 angstroms and different molybdenum proportions, a trend of increasing resistivity with the lapse of time of dipping was obtained with tantalum-molybdenum alloy thin films with molybdenum proportions of 15 atomic % and above. This resistivity increase trend is supposed to be a phenomenon that takes place due to reduced thickness of the tantaslum-molybdenum alloy thin films having been etched with etching solution. From the above results of experiments concerning the corrosion resistance, it is supposed that within the scope of experiments conducted by the inventors the corrosion resistance is greatly influenced by the crystal structure and molybdenum proportion.

From the above experiments concerning the resistivity, X-ray diffraction and corrosion resistance of tantalum-molybdenum alloy thin films, it has been found that the resistivity of these thin films is reduced drastically with the structure transition from the tetragonal crystal structure to the body centered cubid crystal structure. It has further been found that the less the molybdenum proportion the speed of the electrochemical reaction is the lower.

This means that in the manufacture of tantalum-molybdenum alloy thin films with molybdenum proportions ranging from 10 to 15 atomic % by sputtering, the application of a bias ranging from 100 to 500 W permits obtaining a tantalum-molybdenum alloy thin film, which comprises a mixed crystal composed of a body centered cubic structure crystal having the same molybdenum proportion as of a tantalum-molybdenum alloy thin film obtained with a bias of 100 W or below and a body centered cubic/tetragonal mixed crystal with a mixed crystal ratio, i.e., a X-ray diffraction peak intensity ratio of the body centered cubid crystal structure (1, 1, 0) plane to the tetragonal crystal structure (0, 0, 2) plane, is 0.5 or below as well as being low in resistivity, less subject to corrosion, slow in electrochemical reaction and excellent in corrosion resistance.

As for the manufacture margins, it was made clear that the molybdenum proportion range is as wide as 10 to 15 atomic % and also that the bias range is as wide as 100 to 500 W. These wide manufacture margins permit stable manufacture.

As a different example, using a tantalum-molybdenum alloy target with a tantalum proportion of 13.0 atomic % a tantalum-molybdenum alloy thin film was formed with zero bias and a power output of 0.5 kW and in an argon gas atmosphere under a pressure of 1.7 mTorr. The thin film obtained had a tetragonal crystal structure, a molybdenum proportion of 13.7 atomic % and a resistivity of 170 [µΩ·cm]. As a further example, using the same target a tantalum-molybdenum alloy thin film was formed under conditions of an applied bias of 300 W, power of 0.5 kW and an argon gas atmosphere under a pressure of 1.7 mTorr. The thin film obtained had a body centered cubid crystal structure, a molybdenum proportion of 12.2 atomic % and a resistivity of 60 [µΩ·cm].

As shown, when the manufacturing conditions such as the molybdenum proportion of the tantalum-molybdenum alloy target are selected such that the molybdenum proportion of tantalum-molybdenum alloy thin films formed with bias ranging from 0 to 500 W is in a range of 10 to 15 atomic %, it is possible to obtain high resistivity tantalum-molybdenum alloy thin films having excellent corrosion resistance and high reliability and low resistivity tantalum-molybdenum alloy thin films as desired using the same target but by changing the applied bias and other conditions in the manufacture. This is an excellent advantage of this emobdiment that stable manufacture can be ensured with wide manufacture margins.

A second embodiment of the present invention will now be described with reference to Fig. 8. This embodiment is structurally the same as the preceding Figs. 1 to 2(a) to 2(c) embodiment except for that in this embodiment a non-magnetic spacer thin film 13 and electrode thin films 17 (17₁ and 17₂) are formed in lieu of the non-magnetic spacer thin film 3 and electrode thin films 7 (7₁ and 7₂) in the first embodiment. The difference of this embodiment will now be described.

In this embodiment, as the non-magnetic spacer thin film 13 a tantalum-molybdenum alloy thin film with a thickness of 200 angstroms and a molybdenum proportion of 13.7 atomic % and having a tetragonal crystal structure is formed by sputtering using a tantalum-molybdenum target with a molybdenum proportion of 13.0 atomic %, without any applied bias, with a power output of 0.5 kW and in an argon gas atmosphere under a pressure of 1.7 mTorr. As the electrode thin films 17 (17₁ and 17₂) a tantalum-molybdenum alloy thin film with a thickness of 200 angstroms and a molybdenum proportion of 12.2 atomic % and having a tetragonal crystal structure is formed by sputtering using the same target as for the non-magnetic spacer thin film 13 as described above, with a bias of 300 W and a power output of 0.5 kW and in an argon gas atmosphere under a pressure of 1.7 mTorr. The other structures and manufacturing steps other than described above are the same as in the previous first embodiment.

The resistances of the magnetoresistive effect heads were measured, and it was found that as small value as 15 Ω can be obtained stably. Heat generation also could be suppressed to a low level. Readback characteristics were further examined, and satisfactory readback waveforms with less noise due to heat could be obtained.

A third embodiment of the invention will now be described with reference to Figs. 9 and 10(a) to 10(d). This embodiment, as shown in Fig. 9, features that it has a first electrode which constitutes side walls of operative zone Tw and is inclined smoothly.

Specifically, this third embodiment, as shown in Figs. 9 and 10(a) to 10(d), has a soft magnetic thin film 2 of a cobalt-zirconium-molybdenum alloy having a thickness of 250 angstroms, a non-magnetic spacer thin film 3 constituted by a tantalum thin film having a thickness of 200 angstroms, and a magnetoresistive effect thin film 4 of a nickel-iron alloy having a thickness of 200 angstroms, these thin films being formed successively by sputtering on an Al₂O₃-TiC tye ceramic substrate 1. As shown in Fig. 19(b), the photoresist 6 was formed to a thickness of 1.2 microns on the laminate, and it was exposed and developed under adequate conditions to form a stencil pattern.

Subsequently, as shown in Fig. 10(c), antiferromagnetic exchange bias thin films 5 (5₁ to 5₃) of an iron-manganese alloy having a thickness of 150 angstroms were formed. Then, as first electrode thin films 7 (7₁ to 7₃) a tantalum-molybdenum alloy thin film with a thickness of 500 angstroms and a molybdenum proportion of 500 angstroms was formed by sputtering on the thin films 5 (5₁ to 5₃) with a bias of 500 W and an output of 1.0 kW and in an argon gas atmosphere under a pressure of 1.7 mTorr. On the thin films 7 (7₁ to 7₃) a gold thin film having a thickness of 1 micron was formed as second electrode thin films 8 (8₁ to 8₃).

The material of the second electrode thin films 8 may be selected as desired so long as it has low resistivity and excellent corrosion resistance. Possibly, it may be substituted for by the tantaslum-molybdenum thin film as the first electrode thin films 7 by increasing the total thickness of the thin film to 1 micron.

Finally, as shown in Fig. 10(d), portions of the iron-manganese alloy antiferromagnetic exchange bias thin film 5₃ with a thickness of 150 angstroms in thickness, first electrode thin film 7₃ constituted by the tantalum-molybdenum alloy thin film with a thickness of 500 angstroms and a molybdenum proportion of 10.8 atomic % and having body centered cubid crystal structure and second electrode thin film 5₃ constituted by the gold thin film with a thickness of 1 micron that are in the operative zone Tw acting as magnetoresistive effect sensor, were removed by using acetone or like organic solvent. A magnetoresistive effect head was thus obtained. The photoresist 6 may be removed more perfectly and more quickly by using ultrasonic wave washing in combination.

The resistance of the magnetoresistive effect head thus obtained was measured, and it was found that as small value as 15 Ω can be obtained stably. Heat generation also could be suppressed to a low level. Readback characteristics were further examined, and satisfactory readback waveforms with less noise due to heat could be obtained.

A fourth embodiment will now be described with reference to Fig. 11. This fourth embodiment, as shown in Fig. 11, is the same as the preceding Fig. 9 third embodiment except for that in this embodiment a non-magnetic spacer thin film 23 and electrode thin films 27 (27₁ and 27₂) are formed in lieu of the non-magnetic spacer thin film 3 and electrode thin films 7 (7₁ and 7₂) in the third embodiment. The different part of this embodiment will now be described.

In this embodiment, as shown in Fig. 11, as the non-magnetic spacer thin film 23 a tantalum-molybdenum alloy thin film with a thickness of 200 angstroms and a molybdenum proportion of 13.7 atomic % and having a tetragonal crystal structure, was formed by sputtering using a tantalum-molybdenum alloy target with a molybdenum proportion of 13.0 atomic %, with no bias and an output of 0.5 kW and in an argon gas atmosphere under a pressure of 1.7 mTorr.

As the electrode thin films 27 (27₁ and 27₂), a tantalum-molybdenum alloy thin film with a thickness of 200 angstroms and a molybdenum proportion of 12.3 atomic %, was formed by sputtering using the same target as for the non-mgnetic spacer thin film 23 with a bias of 300 W and an output of 0.5 kW and in an argon gas structure under a pressure of 1.7 mTorr. The other structures and manufacturing steps are the same as in the case of the above third embodiment.

The resistance of the magnetoresistive effect head thus obtained was measured, and it was found that as small value as 15 Ω can be obtained stably. Heat generation also could be suppressed to a low level. Readback characteristics were further examined, and and it was found that satisfactory readback waveforms with less noise due to heat are obtainable.

A fifth embodiment will now be described with reference to Figs. 11 to 14. This embodiment, as shown in Fig. 12, features in that its soft magnetic thin film 2, non-magnetic spacer thin film 3 and magnetoresistive effect thin film 4 are tapered. This will now be described.

First, as shown in Fig. 13(a), soft magnetic thin film 2 of a cobalt-zirconium-molybdenum alloy with a thickness of 250 angstroms, non-magnetic spacer thin film 3 constituted by a tantalum thin film with a thickness of 200 angstroms and a magnetoresistive effect thin film 4 of nickel-iron alloy with a thickness of 200 angstroms, are laminated by sputtering successively on an Al₂O₃-TiC type ceramic substrate 1. A gold thin film with a thickness of 2,400 angstroms, was then formed as stencil shaft portion metal thin film 10 on the laminate. Then, photoresist 6 was coated to a thickness of 1 micron.

Subsequently, as shown in Fig. 13(b), the photoresist 6 was patterned to a width of 3.5 microns through exposure and development under appropriate conditions. Then, as shown in Fig. 13(c), the stencil shaft portion thin film 10 constituted by the gold thin film was patterned to a width of 1.5 microns through ion milling and etching using an etching solution containing iodine, potassium iodide and water in weight proportions of "1 : 2 : 200". The stencil that is formed from the photoresist 6 and stencil shaft portion thin film 10 as shown in Fig. 13(c), may also be formed by using the sole photoresist described before in connection with the previous third embodiment.

Then, as shown in Fig. 14(a), the soft magnetic thin film 2, non-magnetic spacer thin film 3 and magnetoresistive effect thin film 4 were tapered through ion milling with an inclination angle of 45 degrees. Thereafter, as shown in Fig. 14(b), a hard magnetic tranverse bias thin films 11 (11₁ to 11₃) constituted by a cobalt-chromium-platinum thin film with a thickness of 300 angstroms was formed. Then, a tantalum-molybdenum alloy thin film with a thickness of 500 angstroms and a molybdenum proportion of 10.8 atomic % and having a body centered cubid crystal structure, was sputtering formed as first electrode thin films 7 (7₁ to 7₃) on the thin films 11 (11₁ to 11₃) with a bias of 500 W and an output of 1.0 kW and in an argon gas atmophere under a pressure of 1.7 mTorr. Then, a gold thin film with a thickness of 1 micron was laminated as second electrode thin films 8 (8₁ to 8₃) on the thin films 7 (7₁ to 7₃). The material of the second electrode thin films 8 (8₁ to 8₃) may be selected as desired so long as it has low resistivity and excellent corrosion resistance. It may also be substituted for by the tantalum-molybdenum alloy thin film as the first electrode thin films 7 (7₁ to 7₃) by increasing the total thickness of the thin film to about 1 micron.

Finally, as shown in Fig. 10(c), portions of the hard magnetic tranverse bias thin film 113 constituted by the cobalt-chromium-platinum thin yfilm with thickness of 300 angstroms in thickness, photoresist 6, first electrode thin film 7₃ condstituted by the body centered cubid crystal structure tantalum-molybdenum alloy thin film 7₃ with thickness of 500 angstoms and molybdenum proportion of 10.8 atomic % and second electrode thin film 8₃ constituted by the gold thin film with thickness of 1 micron that are in the operative zone Tw acting as magnetoresistive effect sensor, were removed by using acetone or like organic solvent. The photoresist 6 may be removed more perfectly and more quickly by using ultrasonic wave washing of the like in combination.

The resistance of the magnetoresistive effect head thus obtained was measured, and it was found that as small value as 15 Ω can be obtained stably. As for readback characteristics, satisfactory readback waveforms with Less noise due to heat could be obtained.

A sixth embodiment will now be described with reference to fig. 15. This embodiment is structurally the same as the preceding Fig. 12 fifth embodiment except for that in this embodiment a non-magnetic spacer thin film 33 and electrode thin films 37 (37₁ and 37₂) were formed in lieu of the non-magnetic spacer thin film 3 and first electrode thin films 7 (7₁ and 7₂) in the fifth embodiment. The different part of this embodiment will now be described.

As the non-magnetic spacer thin film 33 of this embodiment, a tantalum-molybdenum alloy thin film with a thickness of 200 angstroms and a molybdenum proportion of 13.7 atomic % and having a tetragonal crystal structure, was formed by sputtering using a tantalum-molybdenum target with a molybdenum proportion of 13.0 atomic %, with no bias and an output of 0.5 kW and in an argon gas atmosphere under a pressure of 1.7 mTorr.

As the electrode thin films 37 (37₁ and 37₂), a tantalum-molybdenum alloy thin film with a thickness of 200 angstroms and a molybdenum proportion of 12.2 artomic %, was formed by sputtering using the same target as for the non-magnetic spacer thin film 3, with a bias of 300 W and an output of 0.5 kW and having a tetragonal crystal structure. The other structures and manufacturing steps are the same as in the case of the previous fifth embodiment.

The resistance of the magnetoresistive effect head thus obtained was measured, and it was found that as small value as approximately 15 Ω can be obtained stably. Heat generation also could be suppressed to a low level. Readback characteristics were further examined, and it was found that satisfactory readback waveforms with less noise due to heat are obtainable.

As has been described in the foregoing, with the constitution and functions according to the present invention an electrode thin film with as low resistivity as about one-fourth of the resistivity of a tantalum thin film and excellent corrosion resistance is obtainable, thus permitting the provision of a magnetoresistive effect head, which can provide for low resistivity as a head element, generates less heat and noise, has satisfactory corrosion resistance and is highly reliable. In addition, a high resistivity non-magnetic sacer thin film and a low resistivity electrode thin film can be formed by using the same target, thus permitting stable provision of a high reliability magnetoresistive effect head at a low cost and with a reduced number of steps. It is thus possible to extremely improve the productivity.

Changes in construction will occur to those skilled in the art and various apparently different modifications and embodiments may be made without departing from the scope of the invention. The matter set forth in the foregoing description and accompanying drawings is offered by way of illustration only. It is therefore intended that the foregoing description be regarded as illustrative rather than limiting.

Each feature disclosed in this specification (which term includes the claims) and/or shown in the drawings may be incorporated in the invention independently of other disclosed and/or illustrated features.

The text of the abstract filed herewith is hereby deemed to be repeated here in full as part of the specification.

## Claims

1. An electrode thin film formed on a predetermined member to cover a predetermined area thereof and functioning as an electrode part, the electrode part being constituted by a tantalum-molybdenum alloy thin film of a crystal system having a body centered cubid crystal structure.

2. An electrode thin film formed on a predetermined member to cover a predetermined area thereof and functioning as an electrode part, the electrode part being constituted by a tantalum-molybdenum alloy thin film of a mixed crystal composed of a crystal system having a body centered cubid crystal structure and a crystal system having a tetragonal system.

3. The electrode thin film according to claim 2, wherein the ratio of the body centered cubid crystal structure to the tetragonal crystal structure in the electrode part is 0.5 or below in terms of the X-ray difraction peak intensity ratio of the body centered cubid crystal (1, 1, 0) plane to the tetragonal crystal structure (0, 0, 2) plane.

4. The electrode thin film according to claim 1, wherein the electrode part is a tantalum-molybdenum alloy thin film with a molybdenum proportion ranging from 10 to 15 atomic %.

5. The electrode thin film according to claim 2, wherein the electrode part is a tantalum-molybdenum alloy thin film with a molybdenum proportion ranging from 10 to 15 atomic %.

6. The electrode thin film according to claim 3, wherein the electrode part is a tantalum-molybdenum alloy thin film with a molybdenum proportion ranging from 10 to 15 atomic %.

7. The electrode thin film according to claim 1, wherein the electrode part has a thickness ranging from 100 to 10,000 angstroms.

8. The electrode thin film according to claim 2, wherein the electrode part has a thickness ranging from 100 to 10,000 angstroms.

9. The electrode thin film according to claim 3, wherein the electrode part has a thickness ranging from 100 to 10,000 angstroms.

10. A method of manufacturing an electrode thin film formed on a predetermined member to cover a predetermined area thereof and functioning as an electrode part, the electrode part being obtained by sputtering in the atmosphere of argon gas or a blend gas obtained by adding 5 % or below of nitrogen gas to argon gas.

11. The method of manufacturing an electrode thin film according to claim 10, wherein bias power ranging from 100 to 500 W is applied in the sputtering.

12. A magnetoresistive effect head comprising a soft magnetic thin film, a non-magnetic spacer thin film, a magnetoresistive effect thin film, an antiferromagnetic exchange bias thin film, a first electrode thin film and a second electrode thin film, these thin films being laminated successively on a substrate, predetermined regions of the antiferromagnetic exchange bias thin film and first and second electrode thin films being cut off to expose the magnetoresistive effect,
the non-magnetic spacer thin film and first electrode thin film being tantalum-molybdenum alloy thin films,
the tantalum-molybdenum alloy thin film as the non-magnetic spacer thin film comprising a crystal of a tetragonal structure crystal system or a mixed crystal composed of body centered cubid crystal structure and tetragonal structure crystal systems with a blend ratio of 0.5 or above in terms of the X-ray diffraction peak intensity ratio of the tetragonal crystal structure (0, 0, 2) plane to the body centered cubid crystal structure (1, 1, 0) plane, haing a molybdenum proportion ranging from 10 to 15 atomic %, and having a thickness ranging from 50 to 350 angstroms.

13. The magnetoresistive effect head according to claim 12, wherein:
the non-magnetic spacer thin film and first electrode thin film are formed by using the same target for sputtering; and
the tantalum-molybdenum alloy thin film as the non-magnetic spacer thin film is formed in the atmosphere of argon gas or a blend gas obtained by adding 5 % or below of nitrogen gas to argon gas and by applying a bias of 100 W or below.

14. A magnetoresistive effect head comprising a soft magnetic thin film, a non-magnetic spacer thin film, a magnetoresistive effect thin film, an antiferromagnetic exchange bias thin film, a first electrode thin film and a second electrode thin film, these thin films being laminated successively on a substrate, predetermined regions of antiferromagnetic exchange bias thin film, a first electrode thin film and a second electrode thin film being cut off to expose the magnetoresistive effect thin film,
the non-magnetic spacer thin film and first electrode thin film being tantalum-molybdenum alloy thin films,
the tantalum-molybdenum alloy thin film as the first electrode thin film comprising a crystal of a body centered cubid crystal structure crystal system or a blend crystal composed of body centered cubid crystal structure and tetragonal structure crystal systems with a blend ratio of 0.5 or below in terms of the X-ray diffraction peak intensity ratio of the tetragonal crystal structure (0, 0, 2) plane to the body centered cubid crystal structure (1, 1, 0) plane, having a molybdenum proportion ranging from 10 to 15 atomic %, and having a thickness of 100 to 10,000 angstroms.

15. The magnetoresistive effect head according to claim 14, wherein:
the non-magnetic spacer thin film and first electrode thin film are formed by using the same target for sputtering; and
the tantalum-molybdenum alloy thin film as the first electrode thin film is formed in the atmosphere or argon gas or a blend gas obtained by adding 5 % or below of nitrogen gas to argon gas and applying a bias ranging from 100 to 500 W.
